# FASCICULE DE BREVET EUROPEEN

(11) **EP 4 033 540 B1**
(45) Date de publication et mention de la délivrance du brevet: **21.10.2026**
(21) Numéro de dépôt: 22151813.7
(22) Date de dépôt: 17.01.2022
(51) Int. Cl.: H10D 30/67, H10D 48/00, H10D 64/27, H10D 86/00, B82Y 10/00, H10D 30/40

(54) **DISPOSITIF COMPRENANT DES GRILLES DE COMMANDE ÉLECTROSTATIQUE REPARTIES SUR DEUX FACES OPPOSÉES D'UNE PORTION DE SEMICONDUCTEUR**
VORRICHTUNG MIT ELEKTROSTATISCHEN STEUERGATES, DIE AUF ZWEI GEGENÜBERLIEGENDEN SEITEN EINES HALBLEITERABSCHNITTS VERTEILT SIND
DEVICE COMPRISING ELECTROSTATIC CONTROL GATES DISTRIBUTED ON TWO OPPOSITE SURFACES OF A PORTION OF A SEMICONDUCTOR

(30) Priorité: 18.01.2021 FR 2100454
(43) Date de publication de la demande: 27.07.2022
(73) Titulaire: Commissariat à l'Energie Atomique et aux Energies Alternatives, 75015 Paris (FR)
(72) Inventeur: BEDECARRATS, Thomas, 38054 GRENOBLE CEDEX 09 (FR); CHARBONNIER, Jean, 38054 GRENOBLE CEDEX 09 (FR); VINET, Maud, 38054 GRENOBLE CEDEX 09 (FR); JACQUINOT, Hélène, 38054 GRENOBLE CEDEX 09 (FR); NIQUET, Yann-Michel, 38054 GRENOBLE CEDEX 09 (FR); THOMAS, Candice, 38054 GRENOBLE CEDEX 09 (FR)
(74) Mandataire: Santarelli

(56) Documents cités:
- WO-A1-2017/213647
- WO-A1-2018/063203
- US-A1- 2013 087 766
- US-A1- 2020 185 512

## Description

### DOMAINE TECHNIQUE ET ART ANTERIEUR

L'invention concerne le domaine des dispositifs à grilles de commande électrostatique. L'invention concerne notamment le domaine des dispositifs quantiques, du traitement de l'information quantique et de l'informatique quantique, ainsi que celui des dispositifs CMOS utilisés dans un cryostat à des températures cryogéniques (inférieures à 1 K, voire inférieures à 4 K).

L'informatique quantique est basée sur l'utilisation d'un état quantique à deux niveaux mesurables comme vecteur d'information, appelé qubit ou bit quantique ou encore « quantum bits » en anglais, et des lois de la mécanique quantique (superposition, intrication, mesure) afin d'exécuter des algorithmes. Un dispositif quantique à un ou plusieurs qubits de spin permet de manipuler l'état quantique de ce ou ces qubits.

Les qubits de spin peuvent être formés dans du semi-conducteur, avantageusement du silicium. Les technologies semi-conductrices sont étudiées pour la réalisation de qubits en raison de leur haut potentiel d'intégration, à l'image de l'électronique classique. Des électrons ou des trous sont individuellement confinés dans des puits quantiques se trouvant dans un cryostat à des températures cryogéniques et réalisés au sein de structures de confinement de tailles nanométriques définies de manière électrostatique et, dans le cas du silicium, d'architecture proche de celle des MOSFETs. Ces structures de confinement correspondent à des boîtes quantiques, également appelées « quantum dots » en anglais. Une boîte quantique se comporte comme un puits de potentiel confinant une ou plusieurs charges élémentaires (électrons ou trous) dans une région de semi-conducteur.

L'application d'un champ magnétique statique (par exemple compris entre 100 mT et 1 T) permet de lever la dégénérescence de spin des quasi-particules. Dès lors, chaque quasi-particule constitue un système quantique à deux niveaux mesurables nommés « spin down » et « spin up ». Leur état quantique est une superposition de ces deux états représentés par la direction d'une flèche au sein d'une sphère, nommée sphère de Bloch. La manipulation (rotation) de ces spins est effectuée à l'aide d'une composante alternative du champ magnétique (de fréquence par exemple comprise entre 1 GHz et plusieurs dizaines de GHz) ou à l'aide d'un champ électrique alternatif aux mêmes fréquences dans le cas d'une interaction spin-orbite suffisante (cas des trous dans du silicium). La lecture des spins (up ou down) permet d'extraire une partie de l'information quantique selon sa probabilité d'être dans chaque état, déterminée par la superposition quantique.

Pour contrôler de manière optimale plusieurs boîtes quantiques formées côte à côte dans une même portion de semi-conducteur, il est nécessaire de pouvoir ajuster la profondeur énergétique de chacune des boîtes quantiques dans le semi-conducteur, c'est-à-dire le niveau minimum d'énergie potentielle de chacune des boîtes quantiques, ainsi que la hauteur énergétique des barrières tunnel, ou barrières à effet tunnel, c'est-à-dire le niveau maximum d'énergie potentielle de chacune des barrières tunnel, qui séparent les boîtes quantiques, et ce de manière indépendante.

Le contrôle de la hauteur des barrières tunnel et du potentiel minimum de chaque boîte quantique est réalisé par l'intermédiaire de tensions appliquées sur des grilles de contrôle électrostatique indépendantes. Les solutions proposées jusqu'à présent consistent à définir des grilles de contrôle positionnées directement au-dessus de chaque boîte quantique et de chaque barrière tunnel. Le pas avec lequel les grilles de contrôle positionnées au-dessus des boîtes quantiques sont réalisées, ainsi que celui avec lequel les grilles de contrôle positionnées au-dessus des barrières tunnel sont réalisées, est compris entre 40 nm et 160 nm.

Une contrainte importante pour la réalisation d'un tel dispositif quantique est que la hauteur des barrières tunnel et le potentiel minimum de chaque boîte quantique doivent être définis et contrôlés avec une bonne précision, par exemple de l'ordre de 100 µV. Pour atteindre une telle précision, le matériau dans lequel les boîtes quantiques sont réalisées ne doit pas être dégradé par la présence de dopants résiduels qui se comportent comme des puits de potentiel (un dopant unique peut induire un désordre très localisé de l'ordre de 200 mV). De plus, la densité de défauts aux interfaces des différents matériaux du dispositif quantique, par exemples ceux localisés à l'interface entre le SiO₂ des diélectriques des grilles de commande et le silicium des boîtes quantiques, doit être minimisée. Par exemple, la réalisation des diélectriques des grilles de commande par oxydation thermique du silicium formant les boîtes quantiques permet d'obtenir des densités de défauts de l'ordre de 10¹⁰ défauts/eV/cm⁻² contrairement aux oxydes obtenus par oxydation plasma ou par dépôt à basse température dont les densités de défauts sont comprises entre 10¹¹ et 10¹² défauts/eV/cm⁻².

Afin de définir et contrôler précisément la hauteur des barrières tunnel et le potentiel minimum de la ou de chaque boîte quantique, le document S. De Franceschi et al., "SOI technology for quantum information processing," 2016 IEEE International Electron Devices Meeting (IEDM), San Francisco, CA, 2016, pp. 13.4.1-13.4.4, propose de modifier le champ électrique dans un nanofil de silicium formant les boîtes quantiques, et ainsi modifier la hauteur des barrières tunnel entre les boîtes quantiques ou le potentiel minimum des boîtes quantiques, en appliquant une tension sur le substrat se trouvant en face arrière de la couche de silicium formant les boîtes quantiques et qui sert dans ce cas de grille arrière. Un premier inconvénient de cette solution est que la grille arrière est commune à la totalité du dispositif quantique et qu'elle ne permet pas de moduler individuellement la hauteur de chacune des barrières tunnel. Un deuxième inconvénient de cette solution est que, pour limiter la présence de dopants résiduels, le substrat n'est pas dopé, ce qui implique que la polarisation appliquée par le substrat n'est pas efficace à basse température.

Dans le domaine des dispositifs CMOS réalisés à partir de substrats FDSOI (ou silicium sur isolant totalement déserté), il est connu de réaliser des grilles arrière par implantation localisée de dopants dans des régions de la couche épaisse du substrat. Cette technique n'est toutefois pas adaptée pour réaliser des grilles arrière de dispositifs quantiques. En effet, pour que ces grilles arrière soient conductrices à basse température, il faut que le dopage réalisé soit supérieur à environ 5.10¹⁸ at/cm² à l'interface entre la couche épaisse et la couche diélectrique enterrée du substrat. Or, une telle concentration de dopants exige des profils d'implantation laissant des dopants résiduels dans la couche mince de silicium du substrat. En outre, les dimensions des grilles arrière et des espaces entre ces grilles arrière sont supérieures à 1 µm, ce qui n'est pas compatible avec les dimensions visées pour les dispositifs quantiques. Enfin, les différences de potentiels entre les grilles sont limitées pour ne pas connecter en direct les diodes formées par dopage et ne pas dépasser les tensions de claquage entre 1 V et 2,5 V.

D'autres documents décrivent la réalisation de dispositifs quantiques à partir de substrats massifs de silicium et dans lesquels la hauteur des barrières tunnel et le potentiel minimum de chaque boîte quantique sont contrôlés par des grilles distinctes. Le document de C. H. Yang et al., « Dynamically controlled charge sensing of a few-electron silicon quantum dot », AIP Advances, 1, 042111, 2011, décrit par exemple la réalisation de telles grilles en mettant en œuvre deux ou trois cycles de lithographie successifs, avec recouvrement partiel des différents niveaux pour gérer les problèmes de désalignement. Le document de R. Pillarisetti et al., IEDM 18, propose la réalisation de telles grilles de manière auto-alignée. Ces solutions ont toutefois pour inconvénient, outre la complexité des procédés de fabrication à mettre en œuvre, que les grilles contrôlant la hauteur des barrières tunnel sont fortement couplées de manière capacitive à celles contrôlant le potentiel minimum des boîtes quantiques du fait des surfaces importantes des grilles se trouvant en regard les unes des autres. En outre, les diélectriques de grille ne peuvent pas être réalisés par oxydation thermique et ne peuvent pas être réalisés avec des propriétés électriques équivalentes.

Autres exemples de dispositifs quantiques sont décrits dans les documents US2013/087766 A1 et WO2017/213647 A1. Des problèmes analogues à ceux exposés ci-dessus pour les dispositifs quantiques se posent pour les dispositifs CMOS utilisés dans un environnement cryogénique.

### EXPOSÉ DE L'INVENTION

Un but de la présente invention est de proposer un dispositif à grilles de commande électrostatique qui ne présente pas les inconvénients de l'art antérieur.

Pour cela, la présente invention propose un dispositif tel que défini par la revendication indépendante 1.

Ici, le dispositif correspond à un dispositif quantique à qubit de spin.

Dans ce dispositif, il est proposé de réaliser la ou les première grilles de commande électrostatique (qui contrôlent le niveau minimum d'énergie potentielle dans la ou les premières régions de la portion de semi-conducteur) du côté d'une face de la portion de semi-conducteur opposée à celle du côté de laquelle les deuxièmes grilles de commande électrostatique (qui contrôlent le niveau maximum d'énergie potentielle dans les deuxièmes régions de la portion de semi-conducteur) sont disposées.

Grâce à cette disposition des première(s) et deuxièmes grilles de commande électrostatique, le procédé de fabrication du dispositif est simplifié, notamment du fait que les contraintes dimensionnelles relatives à ces grilles sont réduites par rapport au cas où toutes les grilles de commande électrostatique se trouveraient sur un même côté de la portion de semi-conducteur.

De plus, cette disposition n'implique pas la mise en œuvre d'étapes dégradant le matériau dans lequel les premières et deuxièmes régions sont présentes à cause de la présence de dopants résiduels, et/ou engendrant des importantes densités de défauts aux interfaces des différents matériaux du dispositif.

Ce procédé autorise également la réalisation des premier(s) et deuxièmes diélectriques de grille par oxydation thermique, qui est une technique engendrant de faibles densités de défauts aux interfaces des diélectriques de grille ainsi réalisés, et permettant d'obtenir de bonnes propriétés électriques.

De plus, contrairement aux dispositifs quantiques de l'art antérieur utilisant le substrat pour contrôler le niveau maximum d'énergie potentielle dans plusieurs régions semi-conductrices, formant par exemple des barrières tunnel, la présence des deuxièmes grilles de commande électrostatique permet d'assurer une modulation individuelle des niveaux maximum d'énergie potentielle dans plusieurs régions semi-conductrices lorsque chacune des deuxièmes grilles de commande électrostatique est couplée électriquement à un contact qui lui est propre, ou dédié.

En outre, ce dispositif correspond à un dispositif quantique, celui-ci est efficace quelle que soit sa température de fonctionnement, notamment à basse température.

Cette disposition des grilles de commande électrostatique de chaque côté de la portion de semi-conducteur évite également les forts couplages capacitifs obtenus lorsque toutes les grilles de commande se trouvent sur un même côté de la portion de semi-conducteur.

De plus, les contraintes concernant les dimensions des grilles de commande électrostatique sont moins importantes que lorsqu'elles sont disposées sur un même côté de la portion de semi-conducteur.

Lorsque le dispositif correspond à un dispositif quantique, cette disposition des première et deuxièmes grilles de commande électrostatique permet de définir et contrôler la hauteur des barrières tunnel, formées dans les deuxièmes régions de la portion de semi-conducteur, et le potentiel minimum de la ou de chaque boîte quantique, formée dans la ou les premières régions de la portion de semi-conducteur, avec une très bonne précision, par exemple de l'ordre de 100 µV.

Selon un premier mode de réalisation :
- le dispositif peut correspondre à un dispositif quantique ;
- la première région de la portion de semi-conducteur peut être configurée pour former une boîte quantique d'un premier qubit de spin du dispositif ;
- les deuxièmes régions de la portion de semi-conducteur peuvent être configurées pour former des barrières tunnel entre lesquelles est disposée la boîte quantique du premier qubit de spin.

Le dispositif quantique peut être utilisé avec des spins de trous et/ou des spins d'électrons.

Dans ce dispositif quantique, les diélectriques de grille ne correspondent pas à des oxydes tunnel, c'est-à-dire ne permettent pas le passage des charges par effet tunnel à travers eux.

Dans ce premier mode de réalisation, le dispositif peut comporter en outre des réservoirs de porteurs de charges électriques entre lesquels la ou les premières régions et les deuxièmes régions de la portion de semi-conducteur sont disposées.

Selon une configuration particulière, la distance d₁ peut être supérieure ou égale à environ 10 nm. Cette configuration permet de garantir un espacement suffisant entre la première grille de commande électrostatique et chacune des deuxièmes grilles de commande électrostatique.

Dans ce cas, les distances d₁, dans le plan parallèle aux première et deuxième faces de la portion de semi-conducteur, entre la première droite et chacune des deuxièmes droites peuvent être égales. Ainsi, la première grille de commande électrostatique est disposée à égale distance de chacune des deuxièmes grilles de commande électrostatique se trouvant de part et d'autre de la première grille de commande électrostatique.

De manière avantageuse, les deuxièmes grilles de commande électrostatique peuvent être réalisées avec un pas de répétition compris entre 40 nm et 80 nm.

Selon une configuration particulière, une distance d₂, dans le plan parallèle aux première et deuxième faces de la portion de semi-conducteur, entre une droite perpendiculaire aux première et deuxième faces de la portion de semi-conducteur et passant par un bord latéral de la première portion de matériau électriquement conducteur, et une droite perpendiculaire aux première et deuxième faces de la portion de semi-conducteur et passant par un bord latéral de la deuxième portion de matériau électriquement conducteur d'une des deuxièmes grilles de commande électrostatique, peut être comprise entre 0 et 20 nm. Dans cette configuration particulière, l'espacement le plus petit entre deux flancs de grilles différentes (première et deuxième grilles de commande électrostatique) peut être compris entre 0 et 20 nm. Cette configuration avantageuse, qui ne relève pas du champ d'application des revendications, autorise un recouvrement partiel, mais limité, des régions de la portion de semi-conducteur dont le potentiel est contrôlé par les première(s) et deuxièmes grilles de commande électrostatique. Selon l'invention, les régions de la portion de semi-conducteur dont le potentiel est contrôlé par les grilles sont espacées. Cette configuration évite que le fonctionnement des deuxièmes grilles de commande n'impacte celui de la ou des premières grilles de commande.

Le dispositif peut être tel que :
- la portion de semi-conducteur comporte plusieurs premières régions distinctes et chacune disposée entre au moins deux deuxièmes régions de la portion de semi-conducteur, chaque première région étant séparée d'une première région voisine par l'une des deuxièmes régions ;
- plusieurs premières grilles de commande électrostatique chacune disposée en contact direct avec l'une des premières régions de la portion de semi-conducteur et configurée pour contrôler un niveau minimum d'énergie potentielle dans ladite une des premières régions de la portion de semi-conducteur.

Lorsque le dispositif correspond à un dispositif quantique, cette configuration permet de réaliser plusieurs qubits de spin alignés dans une même portion de semi-conducteur.

De manière avantageuse, les premières grilles de commande électrostatique peuvent être réalisées avec un pas de répétition compris entre 40 nm et 80 nm.

La portion de semi-conducteur peut correspondre à un nanofil de semi-conducteur.

Dans une configuration particulière, les premières régions peuvent être agencées en formant un premier réseau bidimensionnel dans la portion de semi-conducteur et les deuxièmes régions peuvent être agencées en formant un deuxième réseau bidimensionnel dans la portion de semi-conducteur.

Le dispositif peut comporter en outre des moyens d'application d'au moins un premier potentiel électrique sur chacune des premières portions de matériau électriquement conducteur et d'au moins un deuxième potentiel électrique, de valeur indépendante de celle du premier potentiel électrique, sur chacune des deuxièmes portions de matériau électriquement conducteur.

L'épaisseur de la portion de semi-conducteur peut être comprise entre 10 nm et 20 nm, ou entre 10 nm et 15 nm, et/ou l'épaisseur de chacun des premier et deuxièmes diélectriques de grille peut être compris entre 2 nm et 15 nm, ou entre 2 nm et 10 nm, voire entre 2 nm et 5 nm.

Selon un deuxième mode de réalisation, le dispositif peut correspondre à un dispositif CMOS.

L'invention concerne également un procédé de réalisation d'un dispositif, tel que défini par la revendication 13.

Selon une configuration particulière, la première grille de commande électrostatique et les deuxièmes grilles de commande électrostatique peuvent être réalisées en mettant en œuvre les étapes suivantes :
- réalisation du premier diélectrique de grille et de la première portion de matériau électriquement conducteur de la première grille de commande électrostatique sur la première face de la portion de semi-conducteur qui fait partie d'un premier substrat ;
- dépôt d'au moins une première couche diélectrique recouvrant la première grille de commande électrostatique et des parties de la première face de la portion de semi-conducteur non recouvertes par la première grille de commande électrostatique ;
- solidarisation de la première couche diélectrique avec une deuxième couche diélectrique d'un deuxième substrat ;
- retrait du premier substrat de manière à révéler la deuxième face de la portion de semi-conducteur ;
- réalisation du deuxième diélectrique de grille et de la deuxième portion de matériau électriquement conducteur de chacune des deuxièmes grilles de commande électrostatique sur la deuxième face de la portion de semi-conducteur.

Les premier et deuxièmes diélectriques de grille peuvent être réalisés par la mise en œuvre d'une oxydation thermique de la portion de semi-conducteur.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1 et 2 représentent schématiquement des vues en coupe d'un dispositif quantique selon un premier mode de réalisation ;
- les figures 3 à 9 représentent schématiquement des étapes d'un procédé de réalisation du dispositif quantique selon le premier mode de réalisation ;
- la figure 10 représente schématique une vue de dessus du dispositif quantique selon une variante du premier mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

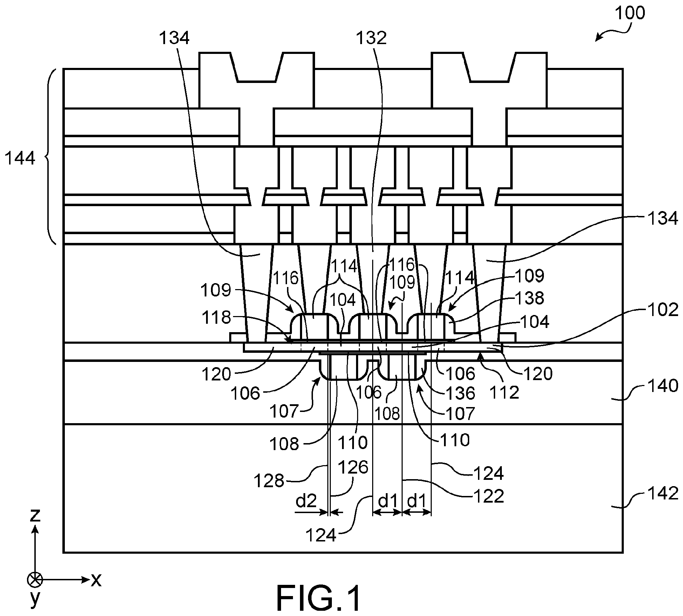

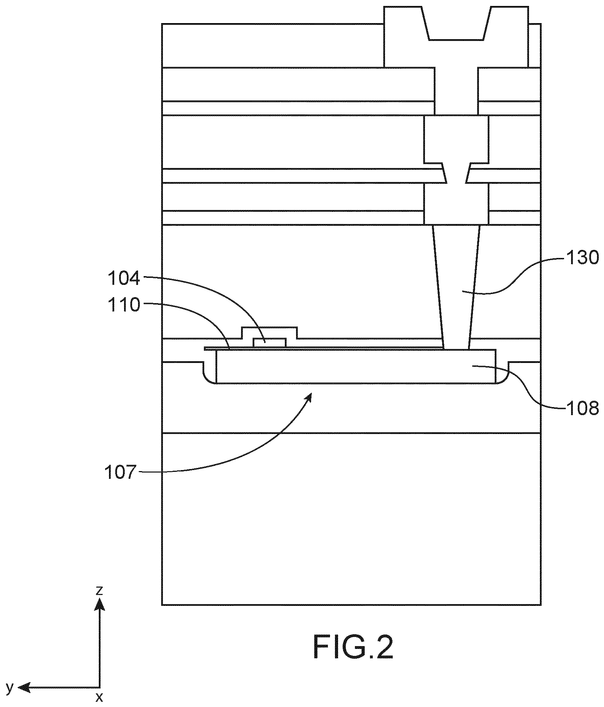

Un dispositif quantique 100 selon un premier mode de réalisation est décrit ci-dessous en lien avec les figures 1 et 2.

Le dispositif 100 comporte une portion de semi-conducteur 102. Le semi-conducteur de la portion 102 correspond par exemple à du silicium et/ou du SiGe, quels que soient leurs isotopes. La portion 102 peut également correspondre à un empilement de plusieurs semi-conducteurs différents, par exemple un empilement de silicium et de SiGe.

Dans l'exemple de réalisation décrit ici, la portion 102 correspond à un nanofil comprenant les caractéristiques suivantes :
- épaisseur (dimension selon l'axe Z) comprise entre environ 5 nm et 200 nm, et avantageusement entre 10 nm et 20 nm, ou avantageusement entre 10 nm et 15 nm ;
- largeur (dimension selon l'axe Y) comprise entre environ entre 20 nm et 120 nm, préférentiellement 40 nm ;
- longueur (dimension selon l'axe X) comprise entre environ 300 nm et 100 µm selon le nombre de qubits désirés dans la portion 102.

La portion de semi-conducteur 102 comporte au moins une première région 104 contre laquelle est disposée au moins une première grille de commande électrostatique 107. Cette première grille de commande électrostatique 107 comprend au moins une première portion de matériau électriquement conducteur 108 et au moins un premier diélectrique de grille 110 disposé entre une première face 112 de la portion de semi-conducteur 102 et la première portion de matériau électriquement conducteur 108.

La première région 104 disposée entre au moins deux deuxièmes régions 106 de la portion de semi-conducteur 102 contre lesquelles sont disposées des deuxièmes grilles de commande électrostatique 109, chacune disposée contre l'une des deuxièmes régions 106 de la portion de semi-conducteur 102. Chacune des deuxièmes grilles de commande électrostatique 109 comprend au moins une deuxième portion de matériau électriquement conducteur 114 et au moins un deuxième diélectrique de grille 116 disposé entre une deuxième face 118, opposée à la première face 112, de la portion de semi-conducteur 102 et la deuxième portion de matériau électriquement conducteur 114 de la deuxième grille de commande électrostatique 109.

Dans l'exemple de réalisation décrit, les premiers et deuxièmes diélectriques de grille 110, 116 ont chacun une épaisseur comprise entre 2 nm et 15 nm, ou comprise entre 2 nm et 10 nm, voire comprise entre 2 nm et 5 nm, par exemple égale 5 nm. De plus, les premiers et deuxièmes diélectriques de grille 110, 116 comportent par exemple un oxyde de semi-conducteur de bonne qualité, avantageusement réalisé par oxydation thermique, par exemple du SiO₂.

Dans l'exemple de réalisation décrit, les premières et deuxièmes portions de matériau électriquement conducteur 108, 114 ont chacune une épaisseur comprise entre 5 nm et 40 nm, par exemple égale à 10 nm, et comportent par exemple du polysilicium dopé dégénéré et/ou du TiN et/ou du Ta et/ou de l'Al. Chacune des premières et deuxièmes portions de matériau électriquement conducteur 108, 114 peut comporter un empilement de plusieurs matériaux, par exemple métalliques (TiN, Ta, Al, etc.) et/ou de polysilicium.

De manière avantageuse, et comme c'est le cas sur l'exemple de réalisation des figures 1 et 2, le dispositif 100 comporte plusieurs premières régions 104 (deux sur la figure 1) telles que deux premières régions 104 voisines soient séparées par l'une des deuxièmes régions 106.

La ou les premières régions 104 et les deuxièmes régions 106 de la portion de semi-conducteur 102 sont alignées selon une direction qui est parallèle à la longueur du nanofil formé par la portion de semi-conducteur 102 (parallèle à l'axe X sur les figures 1 et 2). Sur la figure 1, les premières régions 104 sont délimitées symboliquement des deuxièmes régions 106 par des traits pointillés.

Les premières et/ou deuxièmes grilles de commande électrostatique 107, 109 sont réalisées avec un pas de répétition compris entre 40 nm et 200 nm, et avantageusement compris entre 40 nm et 80 nm.

Les premières grilles de commande électrostatique 107 ne sont pas alignées, selon une direction perpendiculaire aux première et deuxième faces 112, 118 de la portion de semi-conducteur 102, avec les deuxièmes grilles de commande électrostatique 109. Par exemple, en considérant une première grille de commande électrostatique 107 disposée sous une première région 104 et une deuxième grille de commande électrostatique 109 disposée sur une deuxième région 106 adjacente à la première région 104, une distance d₁, dans un plan parallèle aux première et deuxième faces 112, 118 (correspondant au plan (X,Y) sur les figures 1 et 2), entre une première droite 122 perpendiculaire aux première et deuxième faces 112, 118 et passant par le centre de la première grille de commande électrostatique 107, et une deuxième droite 124 perpendiculaire aux première et deuxième faces 112, 118 et passant par le centre de la deuxième grille de commande électrostatique 109, est supérieure ou égale à environ 10 nm. De manière avantageuse, les distances d₁, dans le plan parallèle aux première et deuxième faces 112, 118, entre la première droite 122 et chacune des deuxièmes droites 124 se trouvant de part et d'autre de la première droite 122 sont égales.

Les premières et deuxièmes grilles de commande électrostatique 107, 109 peuvent être réalisées telles que leurs bords recouvrent ou non une même région de la portion 102. Ainsi, en considérant une première grille de commande électrostatique 107 disposée sous une première région 104 et une deuxième grille de commande électrostatique 109 disposée sur une deuxième région 106 adjacente à la première région 104, une distance d₂, dans un plan parallèle aux première et deuxième faces 112, 118, entre une droite 126 perpendiculaire aux première et deuxième faces 112, 118 et passant par un bord latéral de la première portion de matériau électriquement 108 de la première grille de commande électrostatique 107, et une droite 128 perpendiculaire aux première et deuxième faces 112, 118 et passant par un bord latéral de l'une des deuxièmes portions 114 se trouvant du côté de la première portion de matériau électriquement conducteur 108, est comprise entre 0 et 20 nm, ou avantageusement comprise entre 0 et 10 nm. Autrement dit, en considérant les projections de ces premières et deuxièmes portions 108, 114 dans un même plan parallèle aux première et deuxième faces 112, 118, ces projections sont distantes l'une de l'autre et séparées d'une distance comprise entre 0 et 20 nm ou entre 0 et 10 nm.

Les première et deuxièmes régions 104, 106 de la portion de semi-conducteur 102 sont disposées entre des troisièmes régions 120 de la portion de semi-conducteur 102 qui, sur l'exemple des figures 1 et 2, correspondent à des extrémités de la portion de semi-conducteur 102.

Le dispositif 100 comporte en outre des moyens d'application d'au moins un premier potentiel électrique sur chacune des premières portions de matériau électriquement conducteur 108 et d'au moins un deuxième potentiel électrique, de valeur indépendante de celle du premier potentiel électrique, sur chacune des deuxièmes portions de matériau électriquement conducteur 114.

Pour cela, dans l'exemple de réalisation décrit ici, le dispositif 100 comporte un ou plusieurs premiers contacts électriques 130 (un seul premier contact électrique 130 est visible sur la figure 2) reliés électriquement aux premières portions de matériau électriquement conducteur 108. De manière avantageuse, chacune des premières portions de matériau électriquement conducteur 108 est reliée à un premier contact électrique 130 indépendant des autres premiers contacts électriques 130.

Le dispositif 100 comporte également un ou plusieurs deuxièmes contacts électriques 132 reliés électriquement aux deuxièmes portions de matériau électriquement conducteur 114. De manière avantageuse, chacune des deuxièmes portions de matériau électriquement conducteur 114 est reliée à un deuxième contact électrique 132 indépendant des autres deuxièmes contacts électriques 132.

Enfin, le dispositif 100 comporte également des troisièmes contacts électriques 134 reliés électriquement aux réservoirs de porteurs de charges électriques 120.

Les contacts électriques 130, 132 et 134 comportent par exemple au moins un métal et/ou du polysilicium.

Les premières grilles de commande électrostatique 107 sont recouvertes d'au moins une première couche diélectrique 136 comprenant par exemple du nitrure de silicium, et les deuxièmes grilles de commande électrostatique 109 sont recouvertes d'au moins une deuxième couche diélectrique 138 comprenant par exemple du nitrure de silicium. Les matériaux des première et deuxième couches diélectriques 136, 138 peuvent être choisis de manière à servir, lors de la réalisation du dispositif 100, de matériaux d'arrêt de gravure. De plus, ces couches diélectriques 136, 138 servent également à former des espaceurs diélectriques recouvrant les flancs latéraux des premières et deuxièmes grilles de commande électrostatique 107, 109.

La première couche diélectrique 136 est en contact avec une couche diélectrique 140 comportant par exemple du SiO₂ et reposant sur un substrat 142 comprenant par exemple du semi-conducteur. La deuxième couche diélectrique 138 est recouverte par un ou plusieurs niveaux d'interconnexions électriques 144 au travers desquels sont réalisés les contacts électriques 130, 132, 134.

Le dispositif 100 comporte donc, dans ce premier mode de réalisation, au moins un premier qubit de spin réalisé dans la portion de semi-conducteur 102 et comprenant une boîte quantique formée dans la première région 104 de la portion de semi-conducteur 102 et disposée entre au moins deux barrières tunnel chacune formée dans une des deuxièmes régions 106 de la portion de semi-conducteur 102. La première grille de commande électrostatique 107 est configurée pour contrôler un niveau minimum d'énergie potentielle de la boîte quantique du premier qubit, et les deuxièmes grilles de commande électrostatique 109 sont chacune configurée pour contrôler un niveau maximum d'énergie potentielle d'une des barrières tunnel. Les premières grilles de commande électrostatique 107 ne sont pas destinées à moduler les potentiels des mêmes régions de la portion de semi-conducteur 102 que les deuxièmes grilles de commande électrostatique 109.

Le dispositif 100 comporte également des réservoirs de porteurs de charges électriques formés par les troisièmes régions 120 et entre lesquels la ou les boîtes quantiques et les barrières tunnel sont disposées.

De manière avantageuse, et comme c'est le cas sur les figures 1 et 2, le dispositif 100 comporte plusieurs qubits de spin incluant le premier qubit de spin, formés côte à côte dans la portion de semi-conducteur 102. Sur l'exemple de réalisation des figures 1 et 2, ces qubits de spins sont alignés selon une direction parallèle à l'axe X. Chaque qubit comprend une boîte quantique formée dans une des premières régions 104 de la portion de semi-conducteur 102 distincte de celle des autres qubits de spin et disposée entre au moins deux barrières tunnel chacune formée dans une deuxième région 106 de la portion de semi-conducteur 102 distincte de celle des autres barrières tunnel. Chaque boîte quantique est séparée d'une boîte quantique voisine par l'une des barrières tunnel. Sur l'exemple de réalisation représenté sur les figures 1 et 2, deux qubits de spin sont représentés.

Etant donné que chaque boîte quantique est disposée entre deux barrières tunnel, le dispositif 100 comporte un nombre impair de barrières tunnel lorsqu'il comporte un nombre pair de boîtes quantiques, et le dispositif 100 comporte un nombre pair de barrières tunnel lorsqu'il comporte un nombre impair de boîtes quantiques.

Lorsque le dispositif 100 comporte plusieurs qubits de spin, comme c'est le cas sur l'exemple de réalisation représenté sur les figures 1 et 2, le dispositif 100 comporte plusieurs premières grilles de commande électrostatique 107 chacune disposée contre la première région 104 de la portion de semi-conducteur 102 de l'un des qubits de spin et configurée pour contrôler un niveau minimum d'énergie potentielle de la boîte quantique de ce qubit de spin.

Lorsque chacune des premières portions de matériau électriquement conducteur 108 est reliée à un premier contact électrique 130 indépendant des autres premiers contacts électriques 130, il est possible de contrôler individuellement le niveau minimum d'énergie potentielle de la boîte quantique de chaque qubit. Lorsque chacune des deuxièmes portions de matériau électriquement conducteur 114 est reliée à un deuxième contact électrique 132 indépendant des autres deuxièmes contacts électriques 132, il est possible de contrôler individuellement le niveau maximum d'énergie potentielle de chacune des barrières tunnel.

Dans la configuration précédemment décrite en lien avec les figures 1 et 2, les premières grilles de commande électrostatique 107 contrôlant les niveaux minimum d'énergie potentielle des boîtes quantiques sont disposées du côté du substrat 142, et les deuxièmes grilles de commande électrostatique 109 contrôlant les niveaux maximum d'énergie potentielle des barrières tunnel sont disposées du côté du ou des niveaux d'interconnexions électriques 144. En variante, il est possible que la disposition des premières et deuxièmes grilles de commande électrostatique 107, 109 sur la portion 102 soit inversée, c'est-à-dire que les premières grilles de commande électrostatique 107 soient disposées du côté du ou des niveaux d'interconnexions électriques 144, et que les deuxièmes grilles de commande électrostatique 109 soient disposées du côté du substrat 142.

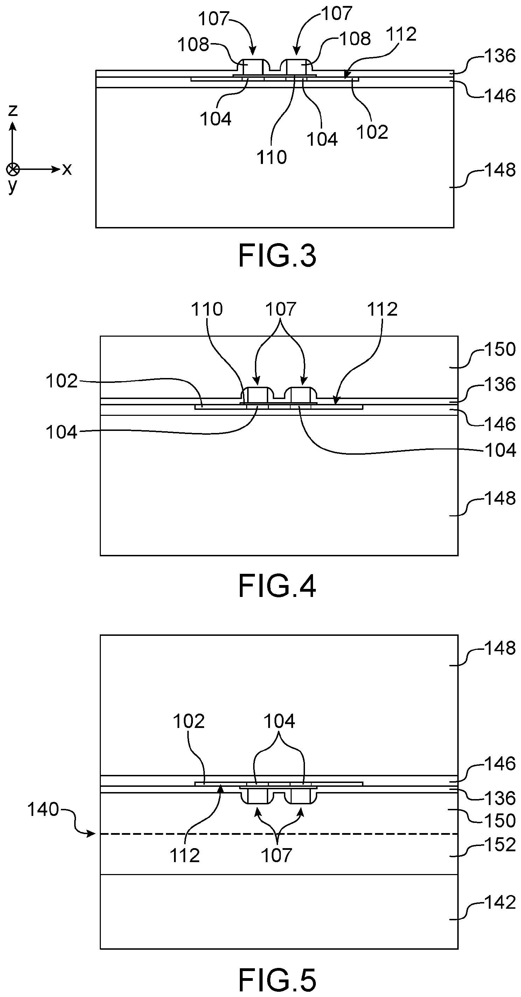

Un procédé de réalisation du dispositif quantique 100 selon le premier mode de réalisation est décrit ci-dessous en lien avec les figures 3 à 9.

Le dispositif 100 est réalisé à partir d'une couche de semi-conducteur qui, dans l'exemple de réalisation décrit ici, correspond à la couche superficielle d'un substrat de type semi-conducteur sur isolant, et plus particulièrement de type SOI (« Silicon-On-Insulator » en anglais, ou silicium sur isolant). La couche de semi-conducteur comporte ici du silicium et est disposée sur une couche diélectrique enterrée 146, ou BOX (« Buried Oxide » en anglais) du substrat SOI comportant du SiO₂. La couche diélectrique enterrée 146 est disposée sur une couche de substrat 148 servant de support et comprenant ici du silicium.

La couche de semi-conducteur est gravée afin d'obtenir la portion 102 correspondant à la portion restante de la couche de semi-conducteur après cette gravure. Pour cela, un premier masque de gravure, comportant par exemple une résine, est déposé sur la couche de semi-conducteur, puis une lithographie et une gravure sont mises en œuvre afin que la portion restante de semi-conducteur corresponde à la portion 102 dans lequel les boîtes quantiques et les barrières tunnel du dispositif 100 seront réalisées. Le premier masque de gravure est ensuite retiré.

En variante, il est possible de ne pas mettre en œuvre les étapes décrites ci-dessus de gravure de la couche de semi-conducteur lorsque les boîtes quantiques du dispositif 100 sont réalisées directement dans la couche de semi-conducteur.

Un empilement de couches de matériaux destinées à la réalisation de la ou des premières grilles de commande électrostatique 107 est ensuite formé en recouvrant la première face 112 de la portion 102 et les parties de la couche diélectrique 146 non recouvertes par la portion 102. Cet empilement comporte au moins une couche diélectrique destinée à la réalisation du ou des premiers diélectriques de grille 110, et au moins une couche électriquement conductrice destinée à la réalisation de la ou des premières portions de matériau électriquement conducteur 108. Afin de pouvoir graver cet empilement de couches et former la ou les premières grilles de commande électrostatique 107, une couche de masque dur, correspondant par exemple à une couche de SiN d'épaisseur égale à 30 nm, est déposée sur cet empilement. De manière avantageuse, la couche diélectrique de l'empilement est obtenue en mettant en œuvre une oxydation thermique de la première face 112 de la portion 102.

Un deuxième masque de gravure est ensuite déposé sur la couche de masque dur, dont le motif correspond à celui de la ou des première grilles de commande électrostatique 107 à réaliser. La couche de masque dur et l'empilement de couches de matériaux destinées à la réalisation de la ou des premières grilles de commande électrostatique 107 sont ensuite soumis à une lithographie et une gravure selon le motif du deuxième masque de gravure. Les portions restantes de ces couches correspondent à la ou aux premières portions de matériau électriquement conducteur 108 et au ou aux premiers diélectriques de grille 110. L'arrêt de cette gravure peut être défini par la couche diélectrique 146 servant dans ce cas de couche d'arrêt de gravure.

La réalisation de la ou des premières grilles de commande électrostatique 107 définit les emplacements, dans la portion 102, de la ou des premières régions 104 destinées à former les boîtes quantiques et qui correspondent à la ou aux régions de la portion 102 recouvertes par la ou les premières grilles de commande électrostatique 107.

La première couche diélectrique 136, comprenant par exemple du nitrure de semi-conducteur tel que du nitrure de silicium, est déposée sur la structure réalisée, en recouvrant la ou les première grilles de commande électrostatique 107, les parties de la portion 102 non recouvertes par la ou les premières grilles de commande électrostatique 107 ainsi que les éventuelles parties de la couche diélectrique 146 non recouvertes par la portion 102 et par la ou les premières grilles de commande électrostatique 107.

La structure obtenue à ce stade du procédé est représentée sur la figure 3.

Sur la figure 4, une couche diélectrique 150 est ensuite déposée en recouvrant la première couche diélectrique 136, puis planarisée.

Sur la figure 5, la structure réalisée est retournée et solidarisée à un deuxième substrat correspondant au substrat 142. Dans l'exemple de réalisation décrit ici, cette solidarisation est réalisée par collage direct ou collage moléculaire entre la couche diélectrique 150 et une autre couche diélectrique 152, comprenant par exemple de l'oxyde de semi-conducteur, formée sur une face du substrat 142. Les couches diélectriques 150 et 152 forment ensemble la couche diélectrique 140 précédemment décrite en lien avec les figures 1 et 2.

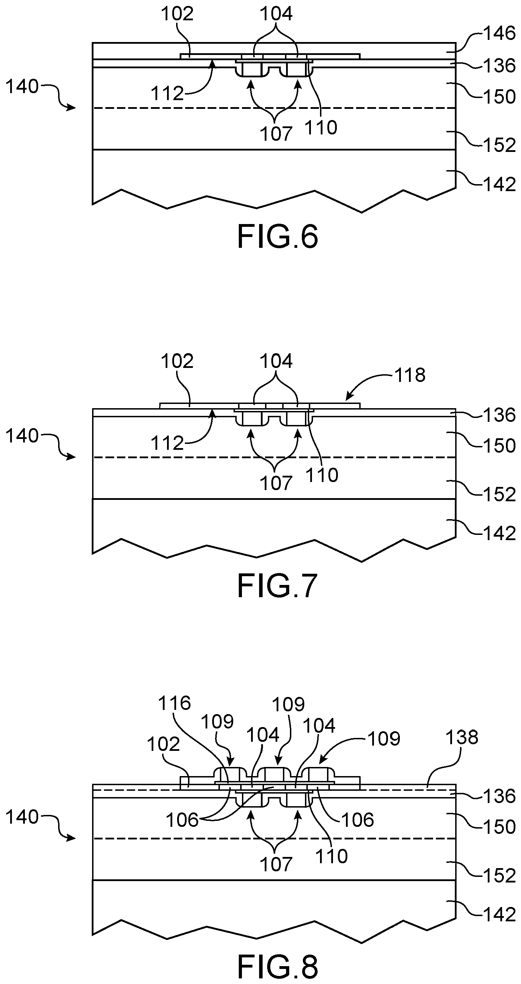

Sur la figure 6, la couche 148 du premier substrat est ensuite retirée, par exemple par abrasion mécanique et attaque chimique sélective vis-à-vis du matériau de la couche diélectrique enterrée 146. Lorsque la couche diélectrique enterrée 146 comporte du SiO₂ et que la couche 148 comporte du silicium, une solution de TMAH peut être utilisée pour cette attaque chimique sélective.

Sur la figure 7, la couche diélectrique enterrée 146 est ensuite retirée, la première couche diélectrique 136 étant ici utilisée comme couche d'arrêt de gravure pour ce retrait. Ce retrait permet de révéler la deuxième face 118 de la portion 102.

À ce stade du procédé, il est possible de réaliser le dopage des troisièmes régions 120 par implantation ionique. Une étape de lithographie d'une couche de masquage est dans ce cas mise en œuvre, préalablement à l'implantation ionique, pour masquer les portions de la portion 102 qui ne sont destinées à être dopées.

Sur la figure 8, les deuxièmes grilles de commande électrostatique 109 sont ensuite réalisées sur la deuxième face 118 de la portion 102, définissant les emplacements des deuxièmes régions 106 de la portion 102. Les deuxièmes grilles de commande électrostatique 109 sont ensuite recouvertes par la deuxième couche diélectrique 138, comprenant par exemple un matériau diélectrique similaire à celui de la première couche diélectrique 136.

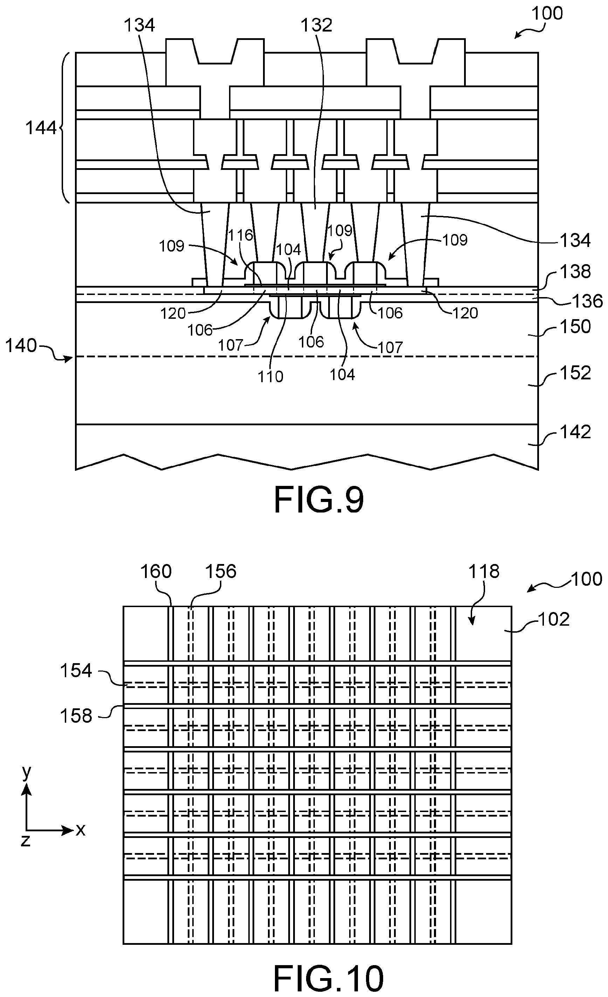

Le dispositif 100 est ensuite achevé, sur la figure 9, en réalisant le ou les niveaux d'interconnexions électriques 144 ainsi que les contacts électriques 130, 132 et 134. Le dispositif 100 obtenu correspond à celui précédemment décrit en lien avec les figures 1 et 2.

En variante du procédé décrit ci-dessus, il est possible que le dopage des troisièmes régions 120 soit réalisé entre le dépôt de la deuxième couche diélectrique 138 et la réalisation du ou des niveaux d'interconnexions électriques 144, par implantation ionique ou par croissance épitaxiale dopé in-situ. Une étape de lithographie est dans ce cas mise en œuvre, préalablement à l'implantation ionique ou la croissance épitaxiale, pour graver des parties de la deuxième couche diélectrique 138 recouvrant les troisièmes régions 120 et ainsi rendre accessibles les troisièmes régions 120.

Un dispositif quantique 100 à qubits de spin selon une variante du premier mode de réalisation est décrit ci-dessous en lien avec la figure 10 qui correspond à une vue de dessus du dispositif 100.

Contrairement à la configuration précédemment décrite en lien avec les figures 1 et 2, les boîtes quantiques ne sont pas réalisées dans un nanofil de semi-conducteur, mais dans une portion de semi-conducteur 102 correspondant à une couche de semi-conducteur.

Plusieurs premières grilles de commande électrostatique, contrôlant les niveaux minimum d'énergie potentielle des boîtes quantiques, sont agencées sous la forme de lignes et portent la référence 154, et d'autres premières grilles de commande électrostatique sont agencées sous la forme de colonnes qui portent la référence 156 contrôlant également les niveaux minimum d'énergie potentielle des boîtes quantiques et qui se superposent aux lignes 154 de premières grilles aux intersections entre les lignes et colonnes 154, 156 de premières grilles de commande électrostatique. Sur la figure 9, les lignes et les colonnes 154, 156 de premières grilles de commande électrostatique sont représentées par des traits pointillés du fait qu'elles sont disposées sous la couche de semi-conducteur, du côté de la première face 112 de cette couche qui n'est pas visible sur la figure 10.

Plusieurs deuxièmes grilles de commande électrostatique, contrôlant les niveaux maximum d'énergie potentielle des barrières tunnel, sont agencées sous la forme de lignes et portent la référence 158, et d'autres deuxièmes grilles de commande électrostatique sont agencées sous la forme de colonnes qui portent la référence 160 et qui se superposent aux lignes de deuxièmes grilles 158 aux intersections entre les lignes et colonnes 158, 160 de deuxièmes grilles de commande électrostatique. Les lignes et colonnes 158, 160 de deuxièmes grilles de commande électrostatique sont disposées sous la couche de semi-conducteur, du côté de la deuxième face 118 de cette couche.

Dans cette configuration, les boîtes quantiques sont agencées en formant un premier réseau bidimensionnel dans la portion de semi-conducteur 102 et les barrières tunnel sont agencées en formant un deuxième réseau bidimensionnel dans la portion de semi-conducteur 102. Les boîtes quantiques sont localisées aux intersections des premières grilles de commande 154, 156 et sont entourées de barrières tunnels se trouvant sous les deuxièmes grilles 158, 160. Le contrôle des profondeurs des boîtes quantiques et des hauteurs des barrières tunnels est réalisé par un adressage de type lignes - colonnes réalisé sur les lignes et colonnes de grilles 154, 156, 158, 160.

Les différentes variantes de réalisation précédemment décrites en lien avec les figures 1 et 2 peuvent s'appliquer au dispositif 100 selon la variante décrite ci-dessus en lien avec la figure 10.

Le dispositif 100 précédemment décrit selon les différents modes et variantes de réalisation peut être utilisé dans un mode de fonctionnement semblable à celui d'un ou plusieurs transistors à effet de champ couplés en série, et fonctionné dans un environnement cryogénique, c'est-à-dire dans un cryostat à des températures cryogéniques (inférieures à 1 K, voire inférieures à 4 K). Dans un tel mode de fonctionnement, les grilles de commande électrostatique 107, 109 sont utilisées comme des grilles de transistors classiques, dont les polarisations contrôlent la conductance entre les troisièmes régions 120 de la structure. Dans un mode de fonctionnement avantageux, les grilles situées au voisinage d'une des faces 112 ou 118 sont polarisées de façon statique dans le but de contrôler et d'ajuster la ou les tensions de seuils du ou des transistors comprenant les grilles situées au voisinage de l'autre face, respectivement 118 ou 112.

## Revendications

1. Dispositif quantique (100) à qubit de spin, comportant au moins :
- une portion de semi-conducteur (102) comprenant au moins une première région (104) disposée entre au moins deux deuxièmes régions (106) et juxtaposée aux deux deuxièmes régions (106) ;
- une première grille de commande électrostatique (107) disposée en contact direct avec la première région (104) de la portion de semi-conducteur (102), configurée pour contrôler un niveau minimum d'énergie potentielle dans la première région (104), et comprenant au moins une première portion de matériau électriquement conducteur (108) et au moins un premier diélectrique de grille (110) disposé en contact direct avec une première face (112) de la portion de semi-conducteur (102), entre la première face (112) et la première portion de matériau électriquement conducteur (108) ;
- des deuxièmes grilles de commande électrostatique (109), chacune disposée en contact direct avec l'une des deuxièmes régions (106) de la portion de semi-conducteur (102) et configurée pour contrôler un niveau maximum d'énergie potentielle dans l'une des deuxièmes régions (106), et comprenant chacune au moins une deuxième portion de matériau électriquement conducteur (114) et au moins un deuxième diélectrique de grille (116) disposé en contact direct avec une deuxième face (118), opposée à la première face (112), de la portion de semi-conducteur (102), entre la deuxième face (118) et la deuxième portion de matériau électriquement conducteur (114),
et dans lequel, dans un plan parallèle aux première et deuxième faces (112, 118), une première droite (122) perpendiculaire aux première et deuxième faces (112, 118) et passant par un centre de la première grille de commande électrostatique (107) est séparée de chaque deuxième droite (124) perpendiculaire aux première et deuxième faces (112, 118) et passant par un centre de l'une des deuxièmes grilles de commande électrostatique (109) d'une distance d₁ non nulle,
**caractérisé en ce que**:
une distance d₂ mesurée dans le plan parallèle aux première et deuxième faces (112, 118) de la portion de semi-conducteur (102), entre une droite (126) perpendiculaire aux première et deuxième faces (112, 118) de la portion de semi-conducteur (102) et passant par un bord latéral de la première portion de matériau électriquement conducteur (108), et une droite (128) perpendiculaire aux première et deuxième faces (112, 118) de la portion de semi-conducteur (102) et passant par un bord latéral de la deuxième portion de matériau électriquement conducteur (114) d'une des deuxièmes grilles de commande électrostatique (109), est comprise entre 0 et 20 nm,
et **en ce que** des projections respectives de la première portion de matériau électriquement conducteur (108) et de la deuxième portion de matériau électriquement conducteur (114) dans un même plan parallèle aux première et deuxième faces étant distantes l'une de l'autre et séparées de la distance d₂.

2. Dispositif (100) selon la revendication 1, dans lequel :
- la première région (104) de la portion de semi-conducteur (102) est configurée pour former une boîte quantique d'un premier qubit de spin du dispositif (100) ;
- les deuxièmes régions (106) de la portion de semi-conducteur (102) sont configurées pour former des barrières tunnel entre lesquelles est disposée la boîte quantique du premier qubit de spin.

3. Dispositif (100) selon la revendication 2, comportant en outre des réservoirs de porteurs de charges électriques (120) entre lesquels la ou les premières régions (104) et les deuxièmes régions (106) de la portion de semi-conducteur (102) sont disposées.

4. Dispositif (100) selon l'une des revendications précédentes, dans lequel la distance d₁ est supérieure ou égale à environ 10 nm.

5. Dispositif (100) selon la revendication 4, dans lequel les distances d₁, dans le plan parallèle aux première et deuxième faces (112, 118) de la portion de semi-conducteur (102), entre la première droite (122) et chacune des deuxièmes droites (124) sont égales.

6. Dispositif (100) selon l'une des revendications précédentes, dans lequel les deuxièmes grilles de commande électrostatique (109) sont réalisées avec un pas de répétition compris entre 40 nm et 80 nm.

7. Dispositif (100) selon l'une des revendications précédentes, dans lequel la distance d₂ est comprise entre 0 et 10 nm.

8. Dispositif (100) selon l'une des revendications précédentes, dans lequel :
- la portion de semi-conducteur (102) comporte plusieurs premières régions (104) distinctes et chacune disposée entre au moins deux deuxièmes régions (106) de la portion de semi-conducteur (102), chaque première région (104) étant séparée d'une première région (104) voisine par l'une des deuxièmes régions (106) ;
- plusieurs premières grilles de commande électrostatique (107) chacune disposée en contact direct avec l'une des premières régions (104) de la portion de semi-conducteur (102) et configurée pour contrôler un niveau minimum d'énergie potentielle dans ladite une des premières régions (104) de la portion de semi-conducteur (102).

9. Dispositif (100) selon la revendication 8, dans lequel les premières grilles de commande électrostatique (107) sont réalisées avec un pas de répétition compris entre 40 nm et 80 nm.

10. Dispositif (100) selon l'une des revendications précédentes, dans lequel les premières régions (104) sont agencées en formant un premier réseau bidimensionnel dans la portion de semi-conducteur (102) et les deuxièmes régions (106) sont agencées en formant un deuxième réseau bidimensionnel dans la portion de semi-conducteur (102).

11. Dispositif (100) selon l'une des revendications précédentes, comportant en outre des moyens d'application d'au moins un premier potentiel électrique sur chacune des premières portions de matériau électriquement conducteur (108) et d'au moins un deuxième potentiel électrique, de valeur indépendante de celle du premier potentiel électrique, sur chacune des deuxièmes portions de matériau électriquement conducteur (114).

12. Dispositif (100) selon l'une des revendications précédentes, dans lequel l'épaisseur de la portion de semi-conducteur (102) est comprise entre 10 nm et 20 nm, et/ou dans lequel l'épaisseur de chacun des premier et deuxième diélectriques de grille (110, 116) est comprise entre 2 nm et 15 nm.

13. Procédé de réalisation d'un dispositif quantique (100) à qubit de spin selon l'une quelconque des revendications 1 à 12, comportant au moins :
- réalisation d'au moins une portion de semi-conducteur (102) comprenant au moins une première région (104) disposée entre au moins deux deuxièmes régions (106) et juxtaposée aux deux deuxièmes régions (106) ;
- réalisation d'une première grille de commande électrostatique (107) disposée en contact direct avec la première région (104) de la portion de semi-conducteur (102), configurée pour contrôler un niveau minimum d'énergie potentielle dans la première région (104), et comprenant au moins une première portion de matériau électriquement conducteur (108) et au moins un premier diélectrique de grille (110) disposé en contact direct avec une première face (112) de la portion de semi-conducteur (102), entre la première face (112) et la première portion de matériau électriquement conducteur (108) ;
- réalisation de deuxièmes grilles de commande électrostatique (109), chacune disposée en contact direct avec l'une des deuxièmes régions (106) de la portion de semi-conducteur (102) et configurée pour contrôler un niveau maximum d'énergie potentielle dans l'une des deuxièmes régions (106), et comprenant chacune au moins une deuxième portion de matériau électriquement conducteur (114) et au moins un deuxième diélectrique de grille (116) disposé en contact direct avec une deuxième face (118), opposée à la première face (112), de la portion de semi-conducteur (102), entre la deuxième face (118) et la deuxième portion de matériau électriquement conducteur (114),
et dans lequel les première et deuxièmes grilles de commande électrostatique (107, 109) sont réalisées telles que, dans un plan parallèle aux première et deuxième faces (112, 118), une première droite (122) perpendiculaire aux première et deuxième faces (112, 118) et passant par un centre de la première grille de commande électrostatique (107) est séparée de chaque deuxième droite (124) perpendiculaire aux première et deuxième faces (112, 118) et passant par un centre de l'une des deuxièmes grilles de commande électrostatique (109) d'une distance d₁ non nulle.

14. Procédé selon la revendication 13, dans lequel la première grille de commande électrostatique (107) et les deuxièmes grilles de commande électrostatique (109) sont réalisées en mettant en œuvre les étapes suivantes :
- réalisation du premier diélectrique de grille (110) et de la première portion de matériau électriquement conducteur (108) de la première grille de commande électrostatique (107) sur la première face (112) de la portion de semi-conducteur (102) qui fait partie d'un premier substrat;
- dépôt d'au moins une première couche diélectrique (136, 150) recouvrant la première grille de commande électrostatique (107) et des parties de la première face (112) de la portion de semi-conducteur (102) non recouvertes par la première grille de commande électrostatique (107) ;
- solidarisation de la première couche diélectrique (136, 150) avec une deuxième couche diélectrique (152) d'un deuxième substrat ;
- retrait du premier substrat de manière à révéler la deuxième face (118) de la portion de semi-conducteur (102) ;
- réalisation du deuxième diélectrique de grille (116) et de la deuxième portion de matériau électriquement conducteur (114) de chacune des deuxièmes grilles de commande électrostatique (109) sur la deuxième face (118) de la portion de semi-conducteur (102).

15. Procédé selon l'une des revendications 13 ou 14, dans lequel les premier et deuxièmes diélectriques de grille (110, 116) sont réalisés par la mise en œuvre d'une oxydation thermique de la portion de semi-conducteur (102).

## Patentansprüche

1. Quantenvorrichtung (100) mit Spin-Qubit, die mindestens umfasst:
- einen Halbleiterabschnitt (102), der mindestens einen ersten Bereich (104) umfasst, der zwischen mindestens zwei zweiten Bereichen (106) angeordnet ist und an die beiden zweiten Bereiche (106) angrenzend ist;
- ein erstes elektrostatisches Steuergitter (107), das in direktem Kontakt mit dem ersten Bereich (104) des Halbleiterabschnitts (102) angeordnet und so eingerichtet ist, dass es einen minimalen potenziellen Energiepegel in dem ersten Bereich (104) steuert, und das mindestens einen ersten Abschnitt aus elektrisch leitfähigem Material (108) und mindestens ein erstes Gitterdielektrikum (110) umfasst, das in direktem Kontakt mit einer ersten Fläche (112) des Halbleiterabschnitts (102) zwischen der ersten Fläche (112) und dem ersten Abschnitt aus elektrisch leitfähigem Material (108) angeordnet ist;
- zweite elektrostatische Steuergitter (109), die jeweils in direktem Kontakt mit einem der zweiten Bereiche (106) des Halbleiterabschnitts (102) angeordnet und so eingerichtet sind, dass sie einen maximalen potenziellen Energiepegel in einem der zweiten Bereiche (106) steuern, und die jeweils mindestens einen zweiten Abschnitt aus elektrisch leitfähigem Material (114) und mindestens ein zweites Gitterdielektrikum (116) umfassen, das in direktem Kontakt mit einer der ersten Fläche (112) gegenüberliegenden zweiten Fläche (118) des Halbleiterabschnitts (102) zwischen der zweiten Fläche (118) und dem zweiten Abschnitt aus elektrisch leitfähigem Material (114) angeordnet ist,
und wobei in einer Ebene parallel zu der ersten und der zweiten Fläche (112, 118) eine erste Geraden (122), die senkrecht zu der ersten und der zweiten Fläche (112, 118) und durch einen Mittelpunkt des ersten elektrostatischen Steuergitters (107) verläuft, von jeder zweiten Geraden (124), die senkrecht zu der ersten und der zweiten Fläche (112, 118) und durch einen Mittelpunkt eines der zweiten elektrostatischen Steuergitter (109) verläuft, um einen Abstand d₁ ungleich Null getrennt ist,
**dadurch gekennzeichnet, dass**:
ein in der Ebene parallel zu der ersten und der zweiten Fläche (112, 118) des Halbleiterabschnitts (102) gemessener Abstand d₂ zwischen einer Geraden (126), die senkrecht zu der ersten und der zweiten Fläche (112, 118) des Halbleiterabschnitts (102) und durch eine seitliche Kante des ersten Abschnitts aus elektrisch leitfähigem Material (108) verläuft, und einer Geraden (128), die senkrecht zu der ersten und der zweiten Fläche (112, 118) des Halbleiterabschnitts (102) und durch eine seitliche Kante des zweiten Abschnitts aus elektrisch leitfähigem Material (114) eines der zweiten elektrostatischen Steuergitter (109) verläuft, zwischen 0 und 20 nm liegt,
und dass die jeweiligen Projektionen des ersten Abschnitts aus elektrisch leitfähigem Material (108) und des zweiten Abschnitts aus elektrisch leitfähigem Material (114) in einer gleichen Ebene parallel zu der ersten und der zweiten Fläche voneinander beabstandet und durch den Abstand d₂ voneinander getrennt sind.

2. Vorrichtung (100) nach Anspruch 1, wobei:
- der erste Bereich (104) des Halbleiterabschnitts (102) so eingerichtet ist, dass er eine Quantenbox eines ersten Spin-Qubits der Vorrichtung (100) bildet;
- die zweiten Bereiche (106) des Halbleiterabschnitts (102) so eingerichtet sind, dass sie Tunnelbarrieren bilden, zwischen denen die Quantenbox des ersten Spin-Qubits angeordnet ist.

3. Vorrichtung (100) nach Anspruch 2, die ferner Behälter für elektrische Ladungsträger (120) umfasst, zwischen denen der erste oder die ersten Bereiche (104) und die zweiten Bereiche (106) des Halbleiterabschnitts (102) angeordnet sind.

4. Vorrichtung (100) nach einem der vorhergehenden Ansprüche, wobei der Abstand d₁ größer oder gleich etwa 10 nm ist.

5. Vorrichtung (100) nach Anspruch 4, wobei die Abstände d₁ in der Ebene parallel zu der ersten und der zweiten Fläche (112, 118) des Halbleiterabschnitts (102) zwischen der ersten Geraden (122) und jeder der zweiten Geraden (124) gleich sind.

6. Vorrichtung (100) nach einem der vorhergehenden Ansprüche, wobei die zweiten elektrostatischen Steuergitter (109) mit einem Wiederholungsabstand zwischen 40 nm und 80 nm hergestellt sind.

7. Vorrichtung (100) nach einem der vorhergehenden Ansprüche, wobei der Abstand d₂ zwischen 0 und 10 nm liegt.

8. Vorrichtung (100) nach einem der vorhergehenden Ansprüche, wobei:
- der Halbleiterabschnitt (102) mehrere separate erste Bereiche (104) umfasst und jeweils zwischen mindestens zwei zweiten Bereichen (106) des Halbleiterabschnitts (102) angeordnet ist, wobei jeder erste Bereich (104) von einem benachbarten ersten Bereich (104) durch einen der zweiten Bereiche (106) getrennt ist;
- mehrere erste elektrostatische Steuergitter (107), die jeweils in direktem Kontakt mit einem der ersten Bereiche (104) des Halbleiterabschnitts (102) angeordnet und so eingerichtet sind, dass sie einen minimalen potenziellen Energiepegel in einem der ersten Bereiche (104) des Halbleiterabschnitts (102) steuern.

9. Vorrichtung (100) nach Anspruch 8, wobei die ersten elektrostatischen Steuergitter (107) mit einem Wiederholungsabstand zwischen 40 nm und 80 nm hergestellt sind.

10. Vorrichtung (100) nach einem der vorhergehenden Ansprüche, wobei die ersten Bereiche (104) so angeordnet sind, dass sie ein erstes zweidimensionales Netz in dem Halbleiterabschnitt (102) bilden, und die zweiten Bereiche (106) so angeordnet sind, dass sie ein zweites zweidimensionales Netz in dem Halbleiterabschnitt (102) bilden.

11. Vorrichtung (100) nach einem der vorhergehenden Ansprüche, ferner umfassend Mittel zum Anlegen von mindestens einem ersten elektrischen Potenzial an jeden der ersten Abschnitte aus elektrisch leitfähigem Material (108) und von mindestens einem zweiten elektrischen Potenzial, dessen Wert unabhängig von dem des ersten elektrischen Potenzials ist, an jeden der zweiten Abschnitte aus elektrisch leitfähigem Material (114).

12. Vorrichtung (100) nach einem der vorhergehenden Ansprüche, wobei die Dicke des Halbleiterabschnitts (102) zwischen 10 nm und 20 nm liegt, und/oder wobei die Dicke jedes des ersten und des zweiten Gitterdielektrikums (110, 116) zwischen 2 nm und 15 nm liegt.

13. Verfahren zum Herstellen einer Quantenvorrichtung (100) mit Spin-Qubit nach einem der Ansprüche 1 bis 12, umfassend mindestens Folgendes:
- Herstellen mindestens eines Halbleiterabschnitts (102), der mindestens einen ersten Bereich (104) umfasst, der zwischen mindestens zwei zweiten Bereichen (106) angeordnet ist und an die beiden zweiten Bereiche (106) angrenzend ist;
- Herstellen eines ersten elektrostatischen Steuergitters (107), das in direktem Kontakt mit dem ersten Bereich (104) des Halbleiterabschnitts (102) angeordnet und so eingerichtet ist, dass es einen minimalen potenziellen Energiepegel in dem ersten Bereich (104) steuert, und das mindestens einen ersten Abschnitt aus elektrisch leitfähigem Material (108) und mindestens ein erstes Gitterdielektrikum (110) umfasst, das in direktem Kontakt mit einer ersten Fläche (112) des Halbleiterabschnitts (102) zwischen der ersten Fläche (112) und dem ersten Abschnitt aus elektrisch leitfähigem Material (108) angeordnet ist;
- Herstellen zweiter elektrostatischer Steuergitter (109), die jeweils in direktem Kontakt mit einem der zweiten Bereiche (106) des Halbleiterabschnitts (102) angeordnet und so eingerichtet sind, dass sie einen maximalen potenziellen Energiepegel in einem der zweiten Bereiche (106) steuern, und die jeweils mindestens einen zweiten Abschnitt aus elektrisch leitfähigem Material (114) und mindestens ein zweites Gitterdielektrikum (116) umfassen, das in direktem Kontakt mit einer der ersten Fläche (112) gegenüberliegenden zweiten Fläche (118) des Halbleiterabschnitts (102) zwischen der zweiten Fläche (118) und dem zweiten Abschnitt aus elektrisch leitfähigem Material (114) angeordnet ist,
und wobei das erste und die zweiten elektrostatischen Steuergitter (107, 109) so hergestellt sind, dass in einer Ebene parallel zu der ersten und der zweiten Fläche (112, 118) eine erste Geraden (122), die senkrecht zu der ersten und der zweiten Fläche (112, 118) und durch einen Mittelpunkt des ersten elektrostatischen Steuergitters (107) verläuft, von jeder zweiten Geraden (124), die senkrecht zu der ersten und der zweiten Fläche (112, 118) und durch einen Mittelpunkt eines der zweiten elektrostatischen Steuergitter (109) verläuft, um einen Abstand d₁ ungleich Null getrennt ist.

14. Verfahren nach Anspruch 13, wobei das erste elektrostatische Steuergitter (107) und die zweiten elektrostatischen Steuergitter (109) durch die Durchführung der folgenden Schritte hergestellt werden:
- Herstellen des ersten Gitterdielektrikums (110) und des ersten Abschnitts aus elektrisch leitfähigem Material (108) des ersten elektrostatischen Steuergitters (107) auf der ersten Fläche (112) des Halbleiterabschnitts (102), der Teil eines ersten Substrats ist;
- Aufbringen mindestens einer ersten dielektrischen Schicht (136, 150), die das erste elektrostatische Steuergitter (107) und die Teile der ersten Fläche (112) des Halbleiterabschnitts (102) bedeckt, die nicht von dem ersten elektrostatischen Steuergitter (107) bedeckt sind;
- Verbinden der ersten dielektrischen Schicht (136, 150) mit einer zweiten dielektrischen Schicht (152) eines zweiten Substrats;
- Entfernen des ersten Substrats, um die zweite Fläche (118) des Halbleiterabschnitts (102) freizulegen;
- Herstellen des zweiten Gitterdielektrikums (116) und des zweiten Abschnitts aus elektrisch leitfähigem Material (114) jedes der zweiten elektrostatischen Steuergitter (109) auf der zweiten Fläche (118) des Halbleiterabschnitts (102).

15. Verfahren nach einem der Ansprüche 13 oder 14, wobei das erste und das zweite Gitterdielektrikum (110, 116) durch die Durchführung einer thermischen Oxidation des Halbleiterabschnitts (102) hergestellt werden.

## Claims

1. A qubit spin quantum device (100), comprising at least:
- a semiconductor portion (102) comprising at least one first region (104) disposed between at least two second regions (106) and juxtaposed to the two second regions (106);
- a first electrostatic control gate (107) disposed in direct contact with the first region (104) of the semiconductor portion (102), configured to control a minimum level of potential energy in the first region (104), and comprising at least one first portion of electrically-conductive material (108) and at least one first gate dielectric (110) disposed in direct contact with a first face (112) of the semiconductor portion (102), between the first face (112) and the first portion of electrically-conductive material (108);
- second electrostatic control gates (109), each disposed in direct contact with one of the second regions (106) of the semiconductor portion (102) and configured to control a maximum level of potential energy in one of the second regions (106), and each comprising at least one second portion of electrically-conductive material (114) and at least one second gate dielectric (116) disposed in direct contact with a second face (118), opposite to the first face (112), of the semiconductor portion (102), between the second face (118) and the second portion of electrically-conductive material (114),
and wherein, in a plane parallel to the first and second faces (112, 118), a first straight line (122) perpendicular to the first and second faces (112, 118) and passing through a center of the first electrostatic control gate (107) is separated from each second straight line (124) perpendicular to the first and second faces (112, 118) and passing through a center of one of the second electrostatic control gates (109) by a non-zero distance d₁,
**characterized in that**:
a distance d₂ measured in the plane parallel to the first and second faces (112, 118) of the semiconductor portion (102), between a straight line (126) perpendicular to the first and second faces (112, 118) of the semiconductor portion (102) and passing through a lateral edge of the first portion of electrically-conductive material (108), and a straight line (128) perpendicular to the first and second faces (112, 118) of the semiconductor portion (102) and passing through a lateral edge of the second portion of electrically-conductive material (114) of one of the second electrostatic control gates (109), is between 0 and 20 nm,
and **in that** respective projections of the first portion of electrically-conductive material (108) and of the second portion of electrically-conductive material (114) in a same plane parallel to the first and second faces are distant from one another and separated by the distance d₂.

2. The device (100) of claim 1, wherein:
- the first region (104) of the semiconductor portion (102) is configured to form a quantum dot of a first spin qubit of the device (100);
- the second regions (106) of the semiconductor portion (102) are configured to form tunnel barriers between which the quantum dot of the first spin qubit is disposed.

3. The device (100) according to claim 2, further comprising electrical charge carrier reservoirs (120) between which the first region(s) (104) and the second regions (106) of the semiconductor portion (102) are disposed.

4. The device (100) according to one of the preceding claims, wherein the distance d₁ is greater than or equal to about 10 nm.

5. The device (100) according to claim 4, wherein the distances d₁, in the plane parallel to the first and second faces (112, 118) of the semiconductor portion (102), between the first straight line (122) and each of the second straight lines (124) are equal.

6. The device (100) according to one of the preceding claims, wherein the second electrostatic control gates (109) are made with a repetition step between 40 nm and 80 nm.

7. The device (100) according to one of the preceding claims, wherein the distance d₂ is between 0 and 10 nm.

8. The device (100) according to any one of the preceding claims, wherein:
- the semiconductor portion (102) comprises several distinct first regions (104) and each disposed between at least two second regions (106) of the semiconductor portion (102), each first region (104) being separated from a neighboring first region (104) by one of the second regions (106);
- several first electrostatic control gates (107) each disposed in direct contact with one of the first regions (104) of the semiconductor portion (102) and configured to control a minimum level of potential energy in said first region (104) of the semiconductor portion (102).

9. The device (100) according to claim 8, wherein the first electrostatic control gates (107) are made with a repetition step between 40 nm and 80 nm.

10. The device (100) according to one of the preceding claims, wherein the first regions (104) are arranged by forming a first two-dimensional array in the semiconductor portion (102) and the second regions (106) are arranged by forming a second two-dimensional array in the semiconductor portion (102).

11. The device (100) according to one of the preceding claims, further comprising means for applying at least one first electrical potential to each of the first portions of electrically-conductive material (108) and at least one second electrical potential, with a value independent of that of the first electrical potential, to each of the second portions of electrically-conductive material (114).

12. The device (100) according to one of the preceding claims, wherein the thickness of the semiconductor portion (102) is between 10 nm and 20 nm, and/or wherein the thickness of each of the first and second gate dielectrics (110, 116) is between 2 nm and 15 nm.

13. A method for making a qubit spin quantum device (100) according to any one of claims 1 to 12, comprising at least:
- making at least one semiconductor portion (102) comprising at least one first region (104) disposed between at least two second regions (106) and juxtaposed to the two second regions (106);
- making a first electrostatic control gate (107) disposed in direct contact with the first region (104) of the semiconductor portion (102), configured to control a minimum level of potential energy in the first region (104), and comprising at least one first portion of electrically-conductive material (108) and at least one first gate dielectric (110) disposed in direct contact with a first face (112) of the semiconductor portion (102), between the first face (112) and the first portion of electrically-conductive material (108);
- making second electrostatic control gates (109), each disposed in direct contact with one of the second regions (106) of the semiconductor portion (102) and configured to control a maximum level of potential energy in one of the second regions (106), and each comprising at least one second portion of electrically-conductive material (114) and at least one second gate dielectric (116) disposed in direct contact with a second face (118), opposite to the first face (112), of the semiconductor portion (102), between the second face (118) and the second portion of electrically-conductive material (114),
and wherein the first and second electrostatic control gates (107, 109) are made such that, in a plane parallel to the first and second faces (112, 118), a first straight line (122) perpendicular to the first and second faces (112, 118) and passing through a center of the first electrostatic control gate (107) is separated from each second straight line (124) perpendicular to the first and second faces (112, 118) and passing through a center of one of the second electrostatic control gates (109) by a non-zero distance d₁.

14. The method according to claim 13, wherein the first electrostatic control gate (107) and the second electrostatic control gate (109) are made by implementing the following steps:
- making the first gate dielectric (110) and the first portion of electrically-conductive material (108) of the first electrostatic control gate (107) on the first face (112) of the semiconductor portion (102) that is part of a first substrate;
- depositing at least one first dielectric layer (136, 150) covering the first electrostatic control gate (107) and parts of the first face (112) of the semiconductor portion (102) not covered by the first electrostatic control gate (107);
- securing the first dielectric layer (136, 150) with a second dielectric layer (152) of a second substrate;
- removing the first substrate so as to reveal the second face (118) of the semiconductor portion (102);
- making the second gate dielectric (116) and the second portion of electrically-conductive material (114) of each of the second electrostatic control gates (109) on the second face (118) of the semiconductor portion (102).

15. The method according to one of claims 13 or 14, wherein the first and second gate dielectrics (110, 116) are made by implementing a thermal oxidation of the semiconductor portion (102).
